# EUROPEAN PATENT APPLICATION

(11) **EP 4 554 338 A1**
(43) Date of publication of application: **14.05.2025**
(21) Application number: 24802149.5
(22) Date of filing: 27.09.2024
(51) Int. Cl.: H05K 1/02, H05K 3/34, H05K 9/00, H01L 23/433, H01L 23/367, H01L 23/04, H01L 23/29, H01L 23/552

(54) **ELECTRONIC DEVICE INCLUDING HEAT TRANSFER BLOCK**

(30) Priority: 27.09.2023 KR 20230130718; 14.12.2023 KR 20230181765
(71) Applicant: Samsung Electronics Co., Ltd, Suwon-si, Gyeonggi-do 16677 (KR)
(72) Inventor: NOH, Hyunwook, Suwon-si Gyeonggi-do 16677 (KR); PARK, Bongchoon, Suwon-si Gyeonggi-do 16677 (KR); SUN, Taewon, Suwon-si Gyeonggi-do 16677 (KR); SONG, Yongjae, Suwon-si Gyeonggi-do 16677 (KR)
(74) Representative: HGF
(86) International application number: PCT/KR2024/014715
(87) International publication number: WO 2025/071325

(57) **Abstract**

An electronic device according to an embodiment of the present disclosure may include a printed circuit board, a first electronic component disposed on the printed circuit board, a second electronic component disposed on the first electronic component, a heat transfer block disposed on the first electronic component and spaced apart from the second electronic component, and a resin material formed between the first electronic component and the second electronic component, in which the heat transfer block includes an injection port formed in the heat transfer block, a discharge port toward a space between the first electronic component and the second electronic component, and a resin flow space formed between the discharge port and the injection port. Various other embodiments are possible.

## Description

### [Technical Field]

The present disclosure relates to an electronic device including a heat transfer block.

### [Background Art]

An electronic component disposed on an electronic device (e.g., a mobile electronic device) may be stacked in a package-on-package manner. For example, a second electronic component (e.g., a dynamic random access memory (DRAM)) and a heat transfer block may be stacked on one surface of a first electronic component (e.g., a system on chip (SOC)). A ball grid array (BGA) may be formed between the first electronic component and the second electronic component.

The information described above may be provided as the related art for the purpose of enhancing the understanding of the present disclosure. None of the foregoing may be asserted as prior art with respect to the present disclosure or used to determine prior art.

### [Disclosure of Invention]

### [Technical Problem]

A resin may be applied to reduce a solder ball crack of a ball grid array (BGA) formed between the first electronic component and the second electronic component.

The resin may be injected into a ball grid array (BGA) positioned between the first electronic component and the second electronic component through a space between the second electronic component and the heat transfer block.

Since the space between the second electronic component and the heat transfer block is narrow, it may be difficult for the resin to be injected into the space between the first electronic component and the second electronic component.

### [Solution to Problem]

An electronic device according to an embodiment of the present disclosure may include a printed circuit board, a first electronic component, a second electronic component, a heat transfer block, and a resin material. The first electronic component may be disposed on the printed circuit board. The second electronic component may be disposed on the first electronic component. The heat transfer block may be disposed on the first electronic component and spaced apart from the second electronic component. The resin material may be formed between the first electronic component and the second electronic component. The heat transfer block may include an injection port formed in the heat transfer block, a discharge port toward a space between the first electronic component and the second electronic component, and a resin flow space formed between the discharge port and the injection port.

An electronic device according to an embodiment of the present disclosure may include a first electronic component, a second electronic component, a heat transfer block, and a resin material. The second electronic component may be electrically coupled to the first electronic component via a plurality of solder balls. The heat transfer block may be disposed on the first electronic component and spaced apart from the second electronic component. The resin material may be formed between the first electronic component and the second electronic component. The heat transfer block may include a resin flow space provided by the heat transfer block. The resin flow space may be configured to guide the resin material between the first electronic part and the second electronic part during manufacturing

A method of disposing a heat transfer block according to an embodiment of the present disclosure may include a contact pad forming operation, a component disposing operation, and a block disposing operation. At the contact pad forming operation, a contact pad may be formed on one surface of a first electronic component. At the component disposing operation, a third electronic component may be disposed on the contact pad formed on the first electronic component. At the block disposing operation, a heat transfer block may be disposed on the first electronic component and surround at least a part of the third electronic component.

A method of disposing a heat transfer block according to an embodiment of the present disclosure may include an integrated block manufacturing operation and a block disposing operation. At the integrated block manufacturing operation, a third electronic component may be attached to a heat transfer block by using a joining member. At the block disposing operation, the heat transfer block to which the third electronic component is attached may be disposed on the first electronic component.

### [Advantageous Effects of Invention]

The electronic device may include the heat transfer blocks and easily transfer the heat generated from the electronic component (e.g., the first electronic component) to another area.

The electronic device the electronic device may include the heat transfer block formed between the inclined surface and the resin flow space, which makes it easy to inject the resin into the ball grid array positioned between the first electronic component and the second electronic component.

The electronic device guides a flow of the resin to the inclined surface and the resin flow space, such that the entire space between the first electronic component and the second electronic component is uniformly filled with the resin.

The electronic device includes the heat transfer block having the resin storage space, which may prevent or reduce an overflow of the resin during the process of injecting the resin.

### [Brief Description of Drawings]

FIG. 1 is a block diagram of an electronic device in a network environment according to an embodiment.
FIG. 2 is a conceptual view illustrating the electronic device according to the embodiment of the present disclosure.
FIG. 3 is a perspective view illustrating the electronic device according to the embodiment of the present disclosure.
FIGS. 4A and 4B are views illustrating a heat transfer block of the electronic device according to the embodiment of the present disclosure.
FIG. 5 is a view illustrating a resin flow space according to the embodiment of the present disclosure.
FIG. 6 is a view illustrating the heat transfer block and a heat transfer member according to the embodiment of the present disclosure.
FIG. 7 is a front view illustrating the electronic device including the heat transfer block according to the embodiment of the present disclosure.
FIG. 8 is a perspective view illustrating the electronic device including the heat transfer block according to the embodiment of the present disclosure.
FIGS. 9A, 9B, 9C, and 9D are views illustrating the heat transfer blocks according to the embodiment of the present disclosure.
FIG. 10 is a view illustrating the electronic device according to the embodiment of the present disclosure.
FIGS. 11A, 11B, and 11C are views illustrating the electronic device including the heat transfer block according to the embodiment of the present disclosure.
FIG. 12 is a view illustrating a first arrangement method according to the embodiment of the present disclosure.
FIG. 13 is a view illustrating a second arrangement method according to the embodiment of the present disclosure.
FIG. 14 is a view illustrating the heat transfer block and the heat transfer member according to the embodiment of the present disclosure.
FIG. 15 is a view illustrating the electronic device including the heat transfer block according to the embodiment of the present disclosure.
FIGS. 16A and 16B are views illustrating the heat transfer block according to the embodiment of the present disclosure.
FIGS. 17A and 17B are views illustrating the heat transfer block according to the embodiment of the present disclosure.
FIGS. 18A, 18B, 18C, 18D, and 18E are views illustrating the heat transfer blocks according to the embodiment of the present disclosure.

### [Mode for the Invention]

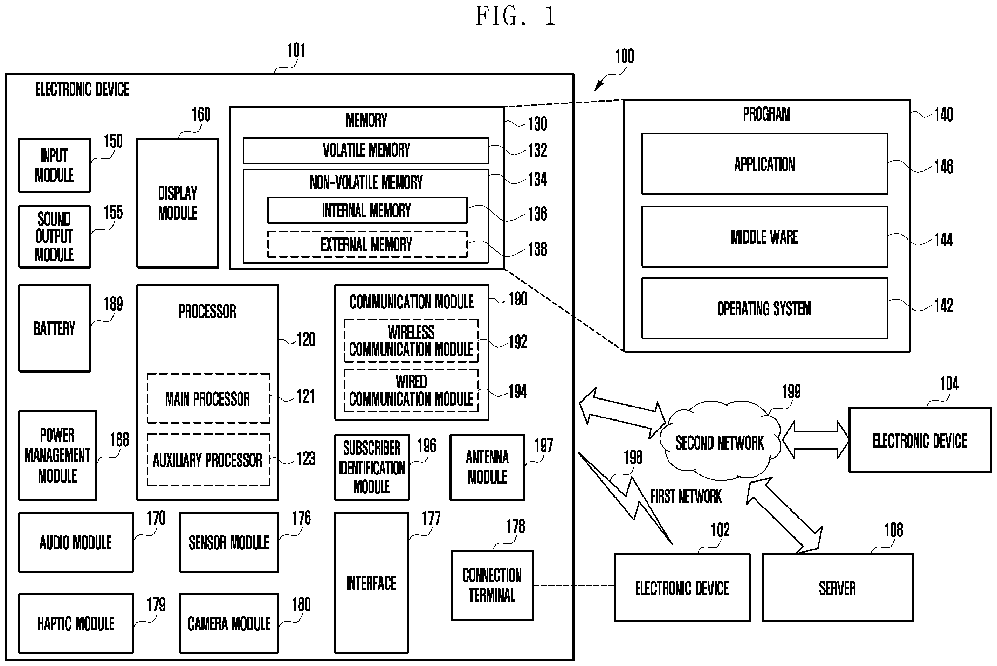

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

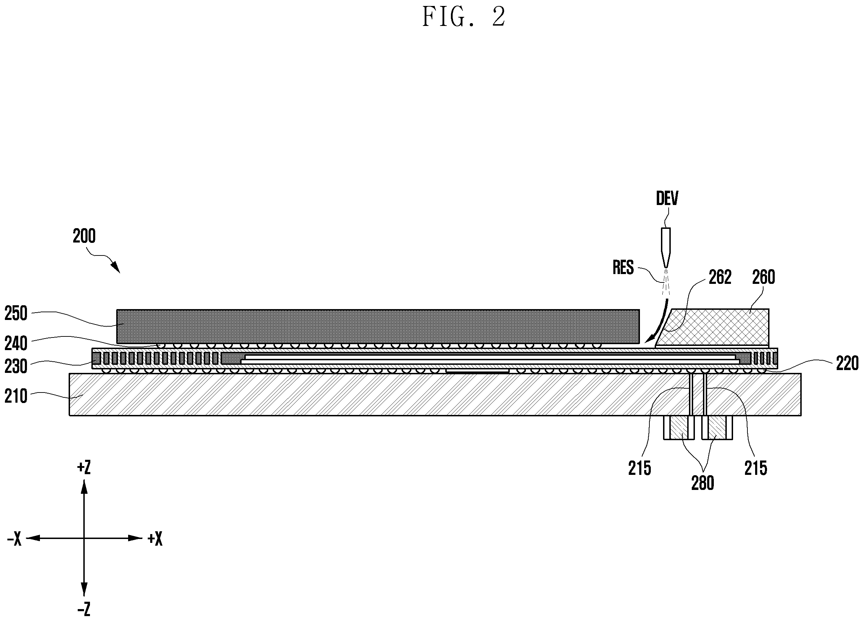

FIG. 2 is a conceptual view illustrating an electronic device 200 according to an embodiment of the present disclosure.

In the description of the electronic device 200 according to the embodiment of the present disclosure, a longitudinal direction of the electronic device 200 may mean an X-axis direction, and a height direction of the electronic device 200 may mean a Z-axis direction. The height direction of the electronic device may be perpendicular to a surface of a first electronic component on which a second electronic component and/or a heat transfer block is arranged. The longitudinal direction of the electronic device may be parallel to a surface of a first electronic component on which a second electronic component and/or a heat transfer block is arranged. A width direction of the electronic device may be parallel to a surface of a first electronic component on which a second electronic component and/or a heat transfer block is arranged. The width direction may be perpendicular to the longitudinal direction.

The electronic device 200 in FIG. 2 may mean the electronic device 101 in FIG. 1 or include at least some of the constituent elements of the electronic device 101 in FIG. 1.

The electronic device 200 according to the embodiment of the present disclosure may include a printed circuit board 210, a first connection part 220, a first electronic component 230 (e.g., first electronic part), a second connection part 240, a second electronic component 250(e.g., second electronic part), a heat transfer block 260, and/or third electronic components 280 (e.g., third electronic part).

In the embodiment, the first electronic component 230 may be disposed on the printed circuit board 210. For example, the first electronic component 230 may be disposed in a positive Z-axis direction of the printed circuit board 210.

In the embodiment, the first electronic component 230 may be a heat generation component that generates heat while operating. In the embodiment, the first electronic component 230 may be a system-on-chip (SOC) made by implementing at least one semiconductor element (e.g., a central processing unit or the like) into one chip.

In the embodiment, the first connection part 220 may be formed between the first electronic component 230 and the printed circuit board 210. The first electronic component 230 may be electrically connected to the printed circuit board 210 through the first connection part 220. In the embodiment, the first connection part 220 may include a ball grid array (BGA) including a plurality of solder balls.

In the embodiment, the second electronic component 250 and the heat transfer block 260 may be disposed on the first electronic component 230. For example, the second electronic component 250 and the heat transfer block 260 may be disposed in the positive Z-axis direction of the first electronic component 230.

In the embodiment, the second electronic component 250 may be a memory device (e.g., a DRAM) configured to store data used by the constituent elements of the electronic device 200.

In the embodiment, the second connection part 240 may be formed between the second electronic component 250 and the first electronic component 230. The second electronic component 250 may be electrically connected to the first electronic component 230 through the second connection part 240. In the embodiment, the second connection part 240 may include a ball grid array (BGA) including a plurality of solder balls.

In the embodiment, the heat transfer block 260 may be disposed at a distance from the second electronic component 250. For example, the heat transfer block 260 may be disposed at a distance in the longitudinal direction (e.g., the X-axis direction) of the electronic device 200 from the second electronic component 250.

In the embodiment, the heat transfer block 260 may serve to move heat generated from the first electronic component 230.

In the embodiment, the heat transfer block 260 may include a thermally conductive material and transfer heat generated from the first electronic component 230. The heat transfer block 260 may include a metallic material with thermal conduction. For example, the heat transfer block 260 may include copper (Cu).

In the embodiment, resin RES may be injected into a space between the second electronic component 250 and the heat transfer block 260 by an external injection device DEV during a process of manufacturing the electronic device 200. The resin RES injected through the injection device DEV may flow toward the second connection part 240 positioned between the first electronic component 230 and the second electronic component 250.

In the embodiment, the resin RES may mean a resin material disposed to fill spaces in the ball grid array (BGA) to prevent or reduce cracks in the solder balls.

In the embodiment, the resin RES may move toward the second connection part 240 and fill the spaces in the ball grid array (BGA).

In the embodiment, the heat transfer block 260 may include an inclined surface 262. For example, the inclined surface 262 may be a surface inclined so that one end is closer to the second electronic component 250 than the other end.

In the embodiment, one end of the inclined surface 262 may mean a distal end of the inclined surface 262 directed in a negative Z-axis direction. The other end of the inclined surface 262 may mean a distal end of the inclined surface 262 directed in the positive Z-axis direction.

In the embodiment, the inclined surface 262 may serve to guide a flow of the resin RES. For example, with reference to FIG. 2, the resin RES may flow toward the second connection part 240 as the movement direction of the resin RES is guided along the inclined surface 262.

In the embodiment, the third electronic component 280 may be disposed on the printed circuit board 210.

In the embodiment, the third electronic component 280 may be disposed on a surface of the printed circuit board 210 opposite to a surface of the printed circuit board 210 on which the first electronic component 230 is disposed. For example, with reference to FIG. 2, the first electronic component 230 may be disposed on a surface of the printed circuit board 210 directed in the positive Z-axis direction, and the third electronic component 280 may be disposed on a surface of the printed circuit board 210 directed in the negative Z-axis direction.

In the embodiment, the third electronic components 280 may be electrically connected to the first electronic component 230 through vias 215 formed in the printed circuit board 210. In the embodiment, one end of the via 215 may be directed toward the first electronic component 230, and the other end of the via 215 may be directed toward the third electronic component 280.

In the embodiment, the third electronic component 280 may be a passive element that accumulates, consumes, or passes supplied energy. For example, the third electronic component 280 may be a capacitor, an inductor, or a resistor.

FIG. 2 illustrates that the second electronic component 250 is disposed on the first electronic component 230. However, the arrangement of the second electronic component 250 may not be limited thereto.

In the embodiment, the second electronic component 250 may be disposed on the printed circuit board 210. The second electronic component 250 may be electrically coupled to the printed circuit board 210 through a plurality of solder balls.

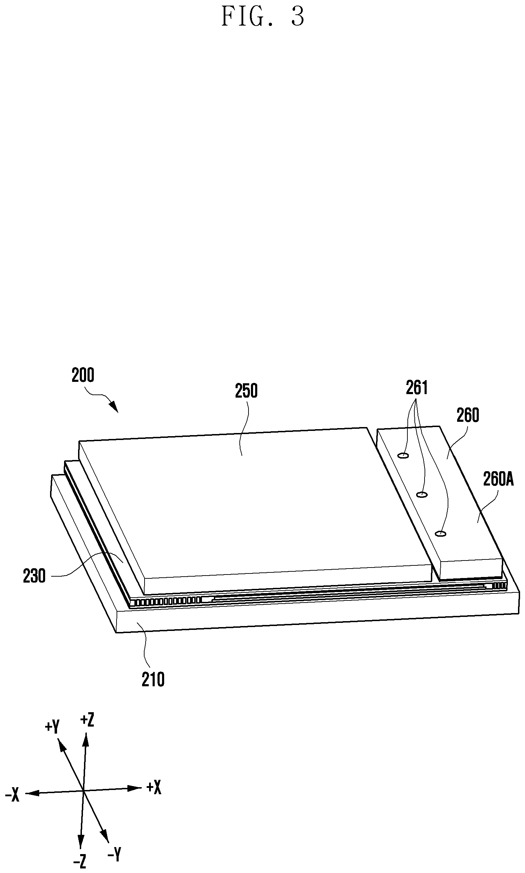

FIG. 3 is a perspective view illustrating the electronic device 200 according to the embodiment of the present disclosure.

In the description of the electronic device 200 according to the embodiment of the present disclosure, the longitudinal direction of the electronic device 200 may mean the X-axis direction, and a width direction of the electronic device 200 may mean a Y-axis direction. The height direction of the electronic device 200 may mean the Z-axis direction.

In the embodiment, the printed circuit board 210, the first electronic component 230, the second electronic component 250, and the heat transfer block 260 may extend in the longitudinal direction (e.g., the X-axis direction), the width direction (e.g., the Y-axis direction), and the height direction (e.g., the Z-axis direction) of the electronic device 200.

In the embodiment, the first electronic component 230 may be disposed on the printed circuit board 210. For example, the first electronic component 230 may be disposed in the positive Z-axis direction based on the printed circuit board 210.

In the embodiment, the second electronic component 250 and the heat transfer block 260 may be disposed on the first electronic component 230. For example, the second electronic component 250 and the heat transfer block 260 may be disposed in the positive Z-axis direction based on the first electronic component 230.

In the embodiment, the heat transfer block 260 may be spaced apart from the second electronic component 250. For example, the second electronic component 250 and the heat transfer block 260 may be disposed at a distance in the X-axis direction.

FIG. 3 illustrates that the heat transfer block 260 is spaced apart from one side surface of the second electronic component 250 in one direction. However, a shape of the heat transfer block 260 and a direction in which the heat transfer block 260 and the second electronic component 250 are spaced apart from each other may be different from the shape illustrated in FIG. 3. For example, in the embodiment, the heat transfer block 260 may be spaced apart from two side surfaces of the second electronic component 250 or spaced apart from three side surfaces of the second electronic component 250. Alternatively, in the embodiment, the heat transfer block 260 may be spaced apart from four side surfaces of the second electronic component 250 and formed to surround an outer periphery of the second electronic component 250.

In the embodiment, the heat transfer block 260 may include at least one injection port (e.g., inlet) 261.

In the embodiment, the injection port 261 may be formed in one surface 260A of the heat transfer block 260. The injection port 261 may be formed in an area of one surface 260A of the heat transfer block 260 positioned to be relatively close to the first electronic component 230.

In the embodiment, the resin RES (see FIG. 2) may be injected into the injection port 261 of the heat transfer block 260 during the process of manufacturing the electronic device 200. The resin RES (see FIG. 2) injected into the injection port 261 may flow to the space between the first electronic component 230 and the second electronic component 250.

In the embodiment, the plurality of injection ports 261 may be formed to be spaced apart from one another at intervals in the width direction (e.g., the Y-axis direction) of the electronic device 200.

In the embodiment, a surface treatment process may be applied to the injection port 261. For example, a coating layer may be formed on an inner surface of the injection port 261 by a coating treatment process. Alternatively, a plasma process or an oxidation treatment process may be applied to the inner surface of the injection port 261.

In the embodiment, in case that the surface treatment process is applied to the injection port 261, the inner surface of the injection port 261 may be formed to be relatively smooth, such that the resin RES (see FIG. 2) with viscosity may easily flow. For example, the inner surface of the injection port 261 may be formed to be relatively smooth, which may prevent or reduce a situation in which the resin RES (see FIG. 2) with viscosity is attached to the periphery of the injection port 261.

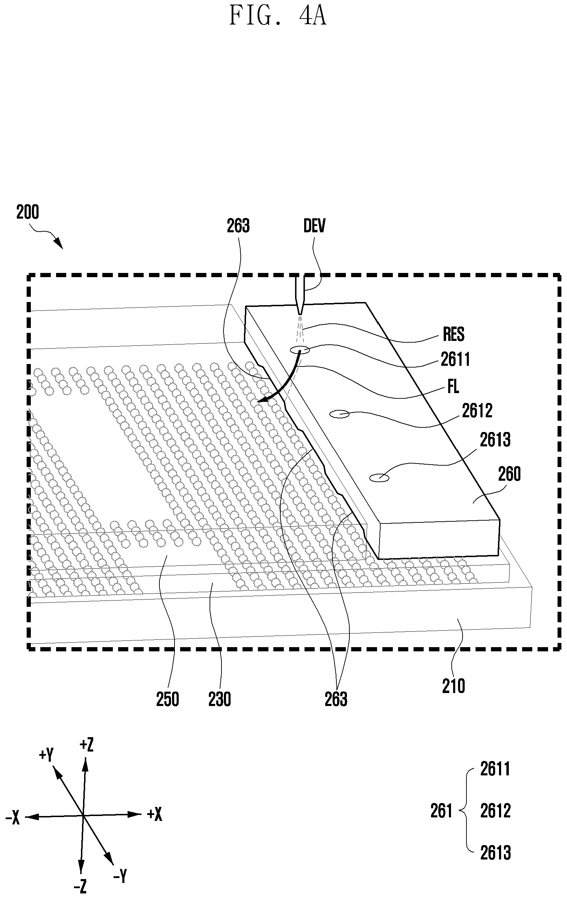

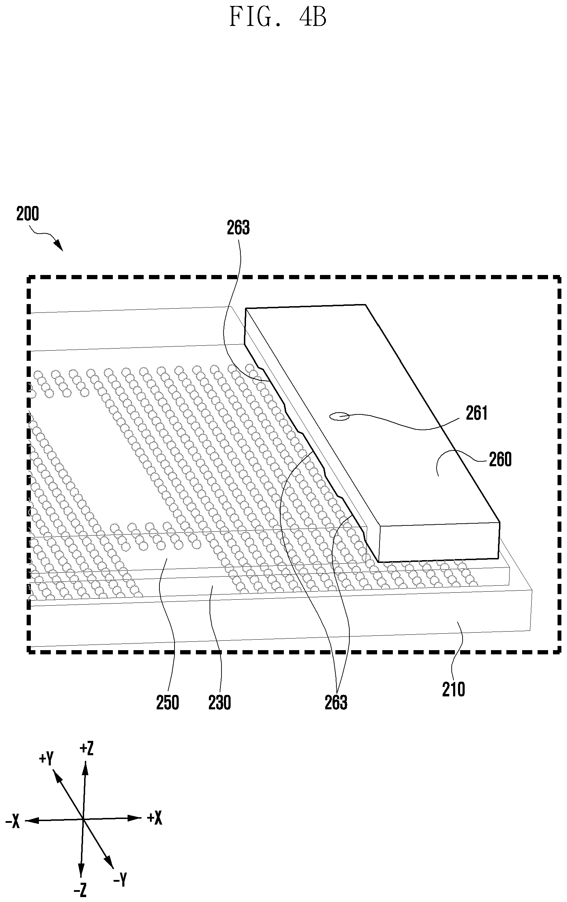

FIGS. 4A and 4B are views illustrating the heat transfer block 260 of the electronic device 200 according to the embodiment of the present disclosure.

With reference to FIG. 4A, the resin RES may be injected into the injection port 261 of the heat transfer block 260 by the injection device DEV during the process of manufacturing the electronic device 200.

In the embodiment, the resin RES injected into the injection port 261 may flow along an inflow path FL.

In the embodiment, the heat transfer block 260 may include a discharge port 263(e.g., outlet). In the embodiment, the discharge port 263 may be directed toward the space between the first electronic component 230 and the second electronic component 250.

In the embodiment, the resin RES injected into the injection port 261 of the heat transfer block 260 may flow along the inflow path FL and be discharged to the outside of the heat transfer block 260 through the discharge port 263 of the heat transfer block 260.

In the embodiment, the space between the second electronic component 250 and the first electronic component 230 may be filled with the resin RES discharged through the discharge port 263 of the heat transfer block 260.

The resin RES may be injected sequentially into the plurality of injection ports 261 during the process of manufacturing the electronic device 200 according to the embodiment. For example, the resin RES may be injected in the order of a first injection port 2611, a second injection port 2612, and a third injection port 2613. In case that it is difficult to inject the resin RES into the first injection port 2611 any further after the resin RES is injected through the first injection port 2611, the resin RES may be injected through the second injection port 2612. In case that it is difficult to inject the resin RES into the second injection port 2612 after the resin RES is injected through the second injection port 2612, the resin RES may be injected through the third injection port 2613.

In the embodiment, the heat transfer block 260 may include the discharge ports 263 larger in number than the injection ports 261. For example, with reference to FIG. 4B, the heat transfer block 260 according to the embodiment may include one injection port 261 and three discharge ports 263. In the embodiment, the resin RES injected into the injection port 261 may be discharged to the outside of the heat transfer block 260 through the discharge ports 263 larger in number than the injection port 261.

The number of injection ports 261 and the number of discharge ports 263 illustrated in FIGS. 4A and 4B are provided for illustrative purposes only. The number of injection ports 261 and the number of discharge ports 263 included in the heat transfer block 260 may not be limited thereto.

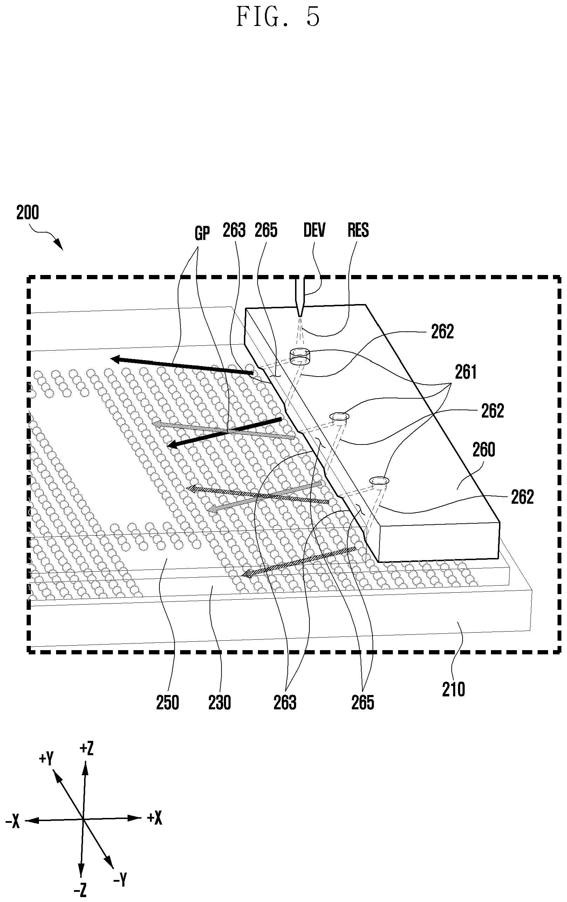

FIG. 5 is a view illustrating a resin flow space 265 according to the embodiment of the present disclosure.

In the embodiment, the electronic device 200 may include the resin RES material formed between the first electronic component 230 and the second electronic component 250. The resin RES material formed between the first electronic component 230 and the second electronic component 250 may be injected in advance through the injection port 261, the resin flow space 265, and the discharge port 263 that guide the resin RES material to the space between the first electronic component 230 and the second electronic component 250.

In the embodiment, the heat transfer block 260 may include the resin flow space 265 connected to the injection port 261 and the discharge port 263.

In the embodiment, one end of the resin flow space 265 may mean a distal end of the resin flow space 265 directed in the negative Z-axis direction, and the other end of the resin flow space 265 may mean a distal end of the resin flow space 265 directed in the positive Z-axis direction.

In the embodiment, the resin flow space 265 may be formed between the injection port 261 and the discharge port 263.

In the embodiment, one end of the resin flow space 265 may be connected to the discharge port 263, and the other end of the resin flow space 265 may be connected to the injection port 261.

In the embodiment, the resin flow space 265 may be inclined with respect to the height direction (e.g., the Z-axis direction) of the electronic device 200. For example, the resin flow space 265 may be formed in a direction inclined with respect to the height direction of the electronic device 200 so that one end is positioned to be closer to the second electronic component 250 than the other end.

In the embodiment, the resin flow space 265 may include a funnel shape. For example, the resin flow space 265 may have a funnel shape having a space that expands toward the discharge port 263 from the injection port 261. In the embodiment, the resin flow space 265 is formed in a funnel shape, which may minimize a decrease in volume of the heat transfer block 260 and guide the flow of the resin RES.

In the embodiment, a width of the resin flow space 265 may mean a length of the resin flow space 265 extending in the width direction (e.g., the Y-axis direction) of the electronic device 200.

In the embodiment, a width of one end of the resin flow space 265 may be larger than a width of the other end of the resin flow space 265.

In the embodiment, the width of one end of the resin flow space 265 is relatively large, which may guide the resin RES so that the resin RES flows in a predetermined direction. For example, because the width of one end of the resin flow space 265 is relatively larger than the width of the other end of the resin flow space 265, the resin RES may not only flow in the longitudinal direction (e.g., the X-axis direction) of the electronic device 200 but also flow along a guide path GP directed in two opposite directions (e.g., the positive Y-axis direction and the negative Y-axis direction) of the resin flow space 265.

In the embodiment, the movement direction of the resin RES injected into the injection port 261 may be guided by the resin flow space 265, and the resin RES may flow along the guide path GP during the process of manufacturing the electronic device 200. The entire space between the first electronic component 230 and the second electronic component 250 may be uniformly filled with the resin RES while the resin RES flows along the guide path GP.

In the embodiment, the inclined surface 262 may be a surface formed at one side of the resin flow space 265. For example, the inclined surface 262 may mean a surface positioned in the positive X-axis direction based on the resin flow space 265. In the embodiment, the inclined surface 262 may mean a surface among the surfaces surrounding the resin flow space 265.

In the embodiment, one end of the inclined surface 262 may be connected to the injection port 261, and the other end of the inclined surface 262 may be connected to the discharge port 263.

In the embodiment, the inclined surface 262 may be inclined with respect to the height direction (e.g., the Z-axis direction) of the electronic device 200. The resin RES introduced into the injection port 261 may move to the space between the first electronic component 230 and the second electronic component 250 while flowing along the inclined surface 262.

In the embodiment, one end of the inclined surface 262 may be a distal end of the inclined surface 262 positioned in the negative Z-axis direction. The other end of the inclined surface 262 may be a distal end of the inclined surface 262 positioned in the positive Z-axis direction.

In the embodiment, one end of the inclined surface 262 may be positioned to be closer to the second electronic component 250 than the other end.

In the embodiment, a width of the inclined surface 262 may mean a length of the inclined surface 262 extending in the width direction (e.g., the Y-axis direction) of the electronic device 200. In the embodiment, a width of one end of the inclined surface 262 may be larger than a width of the other end of the inclined surface 262.

In the embodiment, the width of one end of the inclined surface 262 is relatively large, which may guide the resin RES so that the resin RES flows in a predetermined direction. For example, the resin RES introduced into the injection port 261 may be discharged along the discharge port 263, the movement direction of the resin RES may be guided by the inclined surface 262, such that the resin RES may flow along the guide path GP. The space between the first electronic component 230 and the second electronic component 250 may be uniformly filled with the resin RES while the resin RES flows along the guide path GP.

In the embodiment, the size of the injection port 261 and the size of the discharge port 263 may vary depending on the properties (e.g., viscosity) of the resin RES. In the embodiment, angles at which the resin flow space 265 and the inclined surface 262 are inclined with respect to the height direction (e.g., the Z-axis direction) of the electronic device 200 may vary depending on the properties (e.g., viscosity) of the resin RES.

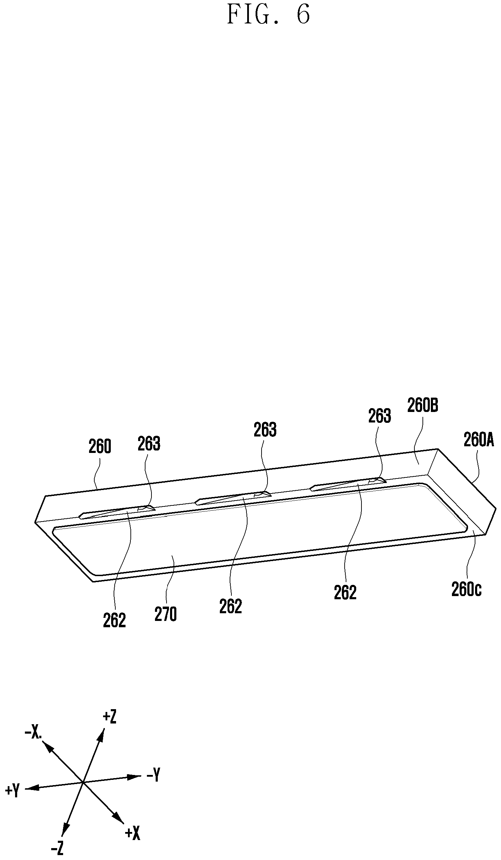

FIG. 6 is a view illustrating the heat transfer block 260 and a heat transfer member 270 according to the embodiment of the present disclosure.

In the embodiment, a side surface 260B of the heat transfer block 260 may be a surface of the heat transfer block 260 directed toward the second electronic component 250.

In the embodiment, the inclined surface 262 may be formed as a part of the heat transfer block 260 is recessed in a direction inclined with respect to the side surface 260B of the heat transfer block 260.

In the embodiment, in case that the inclined surface 262 is formed by recessing a part of the heat transfer block 260, a reduction in volume of the heat transfer block 260 may decrease, and a heat dissipation effect of the heat transfer block 260 may be relatively improved, in comparison with a case in which the inclined surface 262 is formed by cutting one side of the heat transfer block 260.

In the embodiment, at least a part of the inclined surface 262 may be formed to overlap the side surface 260B of the heat transfer block 260 when viewed in a direction substantially perpendicular to the side surface 260B of the heat transfer block 260.

In the embodiment, the heat transfer member 270 may be disposed on the other surface 260C that is a surface directed in the direction opposite to one surface 260A of the heat transfer block 260. For example, the heat transfer member 270 may be disposed on the surface of the heat transfer block 260 directed in the negative Z-axis direction.

In the embodiment, an area of the other surface 260C of the heat transfer block 260 may be larger than an area occupied by the heat transfer member 270. For example, an area of the heat transfer member 270 may be about 60% to 80% of an area of the other surface 260C of the heat transfer block 260.

In the embodiment, the area occupied by the heat transfer member 270 is smaller than the area of the other surface 260C of the heat transfer block 260. Therefore, even though the discharge port 263 is formed as a part of the other surface 260C of the heat transfer block 260 is processed during the process of manufacturing the electronic device 200, the heat transfer member 270 may not be affected by the processing.

In the embodiment, the heat transfer member 270 may be disposed between the heat transfer block 260 and the first electronic component 230 (see FIG. 3). The heat transfer member 270 may transfer heat, which is generated from the first electronic component 230 (see FIG. 3), to the heat transfer block 260. In the embodiment, the heat transfer member 270 may include a heat transfer material (thermal interface material (TIM)).

In the embodiment, the heat transfer member 270 may be disposed so as not to overlap the distal end of the inclined surface 262. For example, with reference to FIG. 6, a distal end of the heat transfer member 270 directed in the negative X-axis direction may be spaced apart from the distal end of the inclined surface 262.

In the embodiment, the heat transfer member 270 may be disposed so as not to overlap the discharge port 263. For example, with reference to FIG. 6, the distal end of the heat transfer member 270 directed in the negative X-axis direction may be spaced apart from the discharge port 263.

In the embodiment, the heat transfer member 270 is spaced apart from the distal end of the inclined surface 262 and the distal end of the discharge port 263, which may prevent or reduce a situation in which the heat transfer member 270 is affected by processes of forming the inclined surface 262 and the discharge port 263.

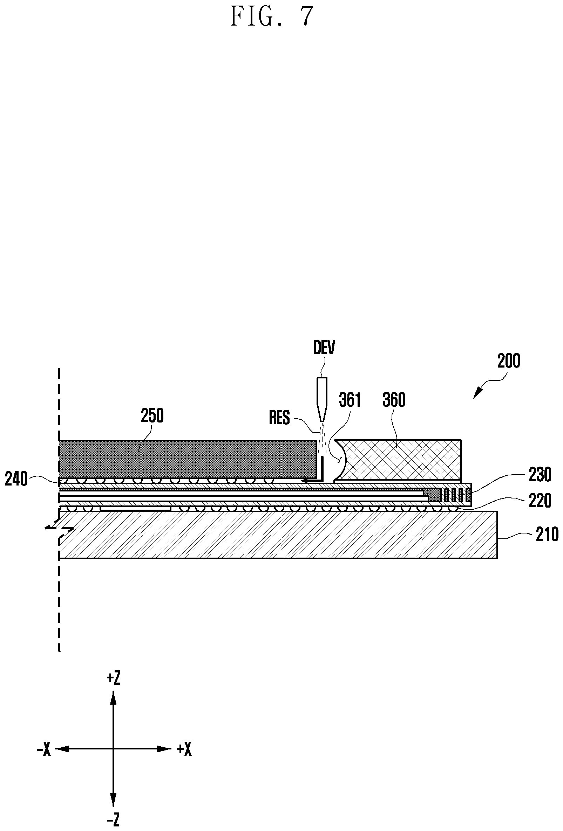

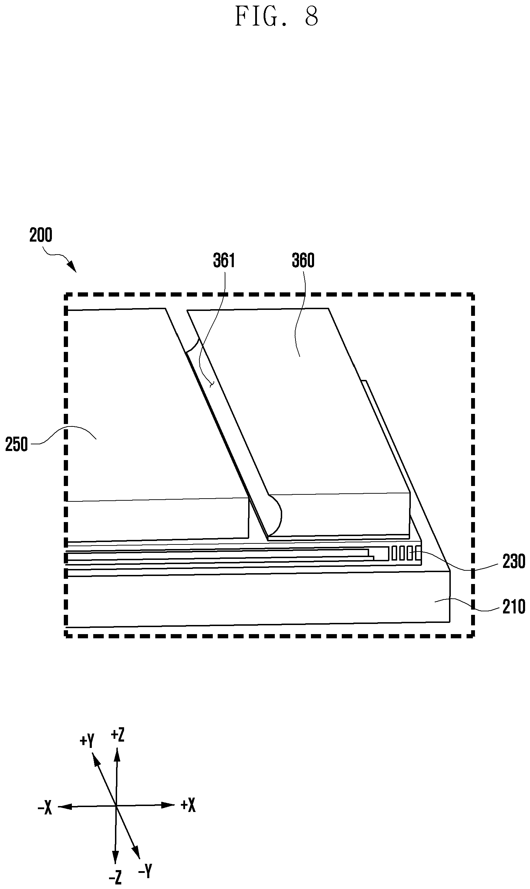

FIGS. 7 and 8 are views illustrating the electronic device 200 including a heat transfer block 360 according to the embodiment of the present disclosure.

FIG. 7 is a front view illustrating the electronic device 200 including the heat transfer block 360 according to the embodiment. FIG. 8 is a perspective view illustrating the electronic device 200 including the heat transfer block 360 according to the embodiment.

With reference to FIGS. 7 and 8, the heat transfer block 360 according to the embodiment may include a resin storage space 361.

In the embodiment, the resin storage space 361 may be formed as a surface of the heat transfer block 360, which faces the second electronic component 250, is concavely recessed in the longitudinal direction (e.g., the X-axis direction) of the electronic device 200.

In the embodiment, the resin storage space 361 may be a space in which the resin RES introduced into the electronic device 200 may be stored. For example, a part of the resin RES, which is introduced into the electronic device 200 by the injection device DEV during the process of manufacturing the electronic device 200, may be stored in the resin storage space 361.

In the embodiment, because the resin RES is stored in the resin storage space 361, which may prevent or reduce an overflow of the resin RES. For example, a period of time, which is equal to or longer than a predetermined period of time, may be required for the resin RES to flow to the second connection part 240 during the process of injecting the resin RES into the electronic device 200. The resin storage space 361 may store the resin RES while the resin RES flows to the second connection part 240 positioned between the first electronic component 230 and the second electronic component 250, which may prevent or reduce an overflow of the resin RES.

FIG. 8 illustrates that the resin storage space 361 is formed in the heat transfer block 360 in the width direction (e.g., the Y-axis direction) of the electronic device 200. However, this configuration is provided for illustrative purposes only, and the shape of the heat transfer block 360 may not be limited thereto. For example, in the heat transfer block 360 according to the embodiment, the resin flow spaces 265 (see FIG. 5) and the resin storage spaces 361 may be formed alternately in the width direction (e.g., the Y-axis direction) of the electronic device 200. In the heat transfer block 360 according to the embodiment, the inclined surfaces 262 (see FIG. 2) and the resin storage spaces 361 may be formed alternately in the width direction (e.g., the Y-axis direction) of the electronic device 200. In the heat transfer block 360 according to the embodiment, the resin flow spaces 265 (see FIG. 5), the inclined surfaces 262 (see FIG. 2), and the resin storage spaces 361 may be formed alternately in the width direction (e.g., the Y-axis direction) of the electronic device 200.

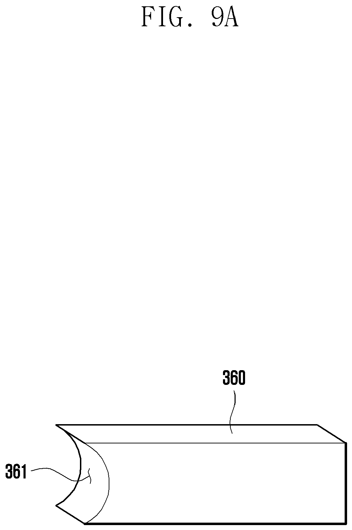

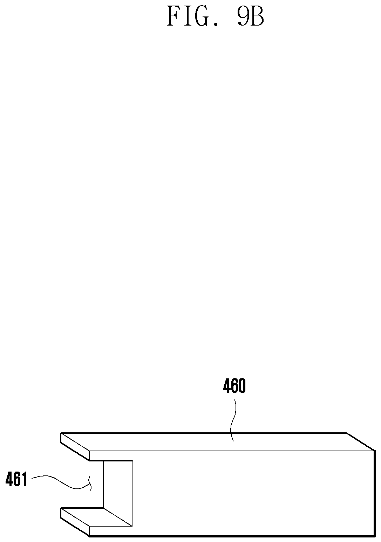

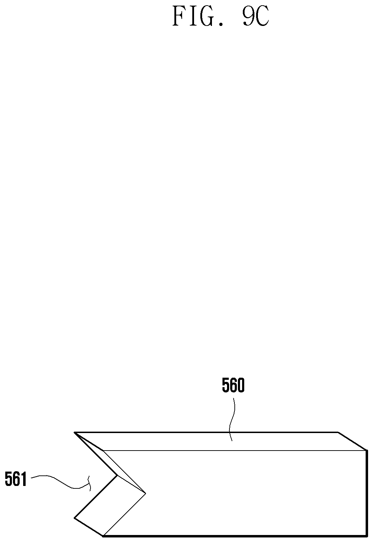

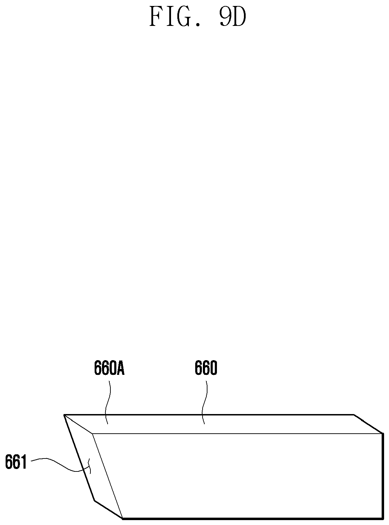

FIGS. 9A, 9B, 9C, and 9D are views illustrating heat transfer blocks 360, 460, 560, and 660 according to the embodiment of the present disclosure.

FIG. 9A is a view illustrating the heat transfer block 360 including a first resin storage space 361. FIG. 9B is a view illustrating the heat transfer block 460 including a second resin storage space 461. FIG. 9C is a view illustrating the heat transfer block 560 including a third resin storage space 561. FIG. 9D is a view illustrating the heat transfer block 660 including a fourth resin storage space 661.

In the embodiment, the resin storage spaces 361, 461, 561, and 661 of the heat transfer blocks 360, 460, 560, and 660 may be formed in various shapes. For example, with reference to FIG. 9A, the first resin storage space 361 according to the embodiment may be formed in a shape in which a part of a surface of the heat transfer block 360, which faces the second electronic component 250 (see FIG. 8), is concavely recessed. With reference to FIG. 9B, the second resin storage space 461 according to the embodiment may be formed as a part of a surface of the heat transfer block 460, which faces the second electronic component 250 (see FIG. 8), is recessed in a rectangular parallelepiped shape. With reference to FIG. 9C, the third resin storage space 561 according to the embodiment may be formed as a part of a surface of the heat transfer block 560, which faces the second electronic component 250 (see FIG. 8), is recessed in a triangular prismatic shape. With reference to FIG. 9D, the fourth resin storage space 661 according to the embodiment is inclined with respect to one surface 660A of the heat transfer block 660, such that one end of the surface of the heat transfer block 660, which faces the second electronic component 250 (see FIG. 8), may be positioned to be farther from the second electronic component 250 (see FIG. 8) than the other end.

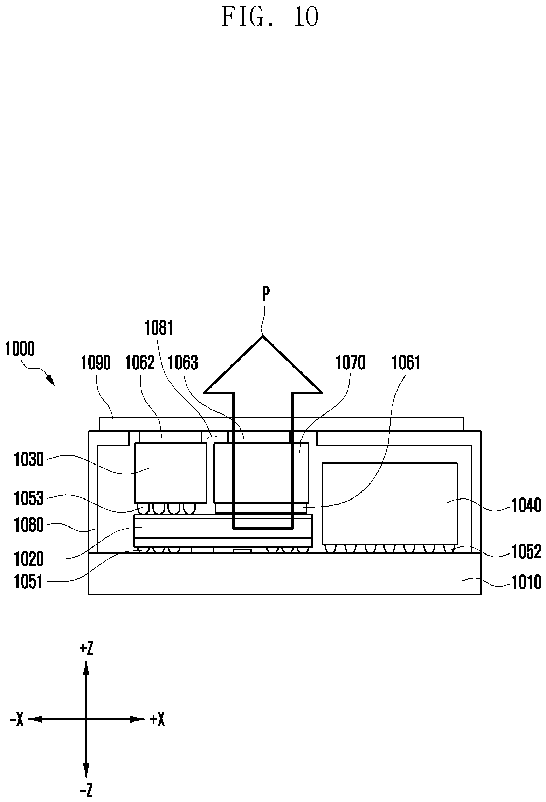

FIG. 10 is a view illustrating an electronic device 1000 according to the embodiment of the present disclosure.

The electronic device 1000 in FIG. 10 may mean the electronic device 200 in FIG. 2 or include at least some of the constituent elements of the electronic device 200 in FIG. 2.

The electronic device 1000 according to the embodiment of the present disclosure may include a printed circuit board 1010, a first electronic component 1020, a second electronic component 1030, a third electronic component 1040, a first connection part 1051, a second connection part 1052, a third connection part 1053, a first heat transfer member 1061, a second heat transfer member 1062, a third heat transfer member 1063, a heat transfer block 1070, a shield can 1080, and/or a shield member 1090.

In the embodiment, the printed circuit board 1010, the first electronic component 1020, the second electronic component 1030, and the heat transfer block 1070 in FIG. 10 may respectively mean the printed circuit board 210, the first electronic component 230, the second electronic component 250, and the heat transfer block 260 in FIG. 2.

In the embodiment, the third electronic component 1040 may be a memory device (e.g., a flash memory) configured to store data used by the constituent elements of the electronic device 1000.

In the embodiment, the first electronic component 1020 and the third electronic component 1040 may be disposed in one direction (e.g., the positive Z-axis direction) of the printed circuit board 1010.

In the embodiment, the first electronic component 1020 and the printed circuit board 1010 may be electrically connected through the first connection part 1051. The third electronic component 1040 and the printed circuit board 1010 may be electrically connected through the second connection part 1052. In the embodiment, the first connection part 1051 and the second connection part 1052 may each include a ball grid array (BGA) including a plurality of solder balls.

In the embodiment, the second electronic component 1030 and the heat transfer block 1070 may be disposed in one direction (e.g., the positive Z-axis direction) of the first electronic component 1020.

In the embodiment, the second electronic component 1030 and the first electronic component 1020 may be electrically connected through the third connection part 1053. In the embodiment, the third connection part 1053 may include a ball grid array (BGA) including a plurality of solder balls.

In the embodiment, the second electronic component 1030 and the heat transfer block 1070 may be disposed to be spaced apart from each other at a distance.

In the embodiment, the first heat transfer member 1061 may be disposed between the first electronic component 1020 and the heat transfer block 1070. In the embodiment, the first heat transfer member 1061 may include a heat transfer material (thermal interface material (TIM)).

In the embodiment, the second heat transfer member 1062 may be disposed on the second electronic component 1030. The third heat transfer member 1063 may be disposed on the heat transfer block 1070. In the embodiment, the second heat transfer member 1062 and the third heat transfer member 1063 may each include a heat transfer material (thermal interface material (TIM)).

In the embodiment, the shield can 1080 may be disposed on one surface of the printed circuit board 1010 and surround the electronic components 1020, 1030, and 1040.

In the embodiment, the shield can 1080 may include a shield can opening 1081. The shield can opening 1081 may be formed at a position that overlaps the first electronic component 1020 and the second electronic component 1030.

In the embodiment, the shield member 1090 may be disposed to cover the shield can opening 1081. In the embodiment, the shield member 1090 may serve to block noise generated by the electronic components 1020, 1030, and 1040. The shield member 1090 may be disposed to cover the shield can opening 1081 and block noise generated by the electronic components 1020, 1030, and 1040.

In the embodiment, the heat generated from the first electronic component 1020 may be transferred to the outside of the electronic device 1000 along a heat transfer path P. For example, with reference to FIG. 10, the heat generated from the first electronic component 1020 may be transferred to the outside of the electronic device 1000 along the heat transfer path P through the first heat transfer member 1061, the heat transfer block 1070, the third heat transfer member 1063, and the shield member 1090.

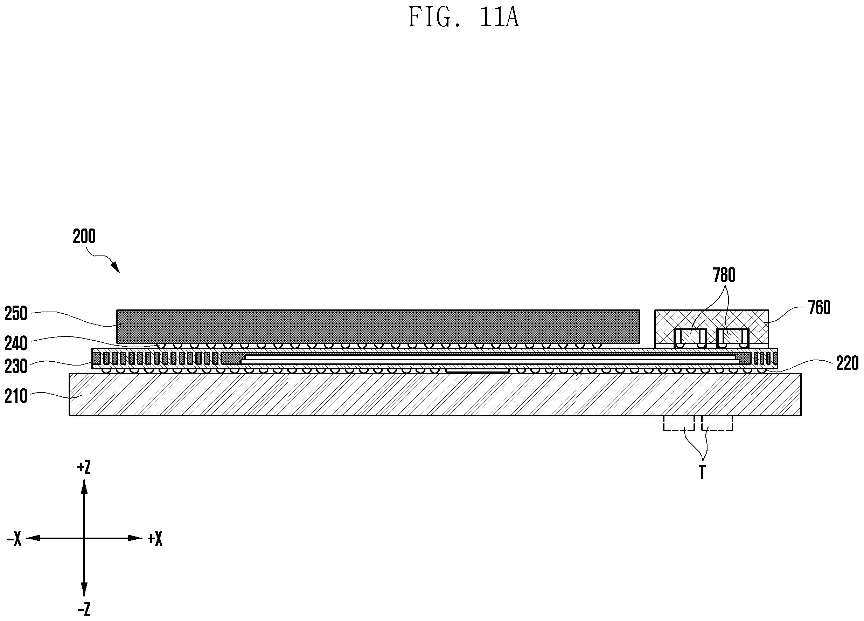

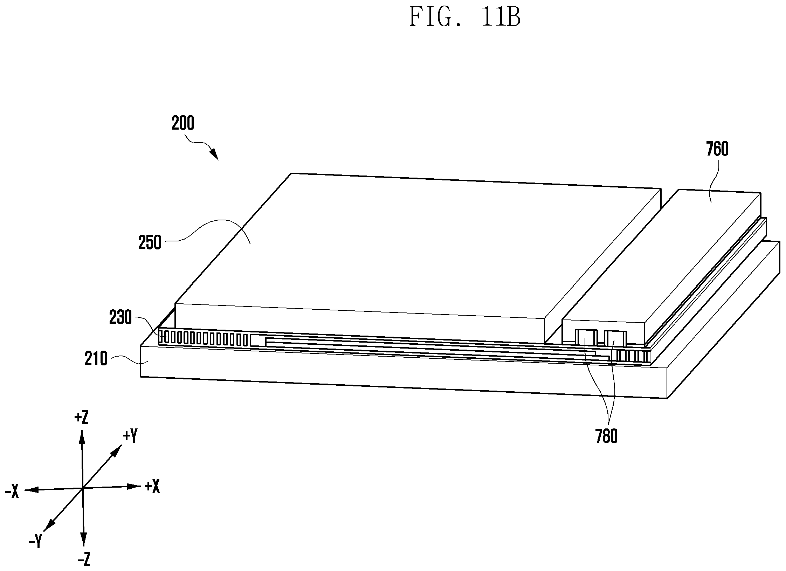

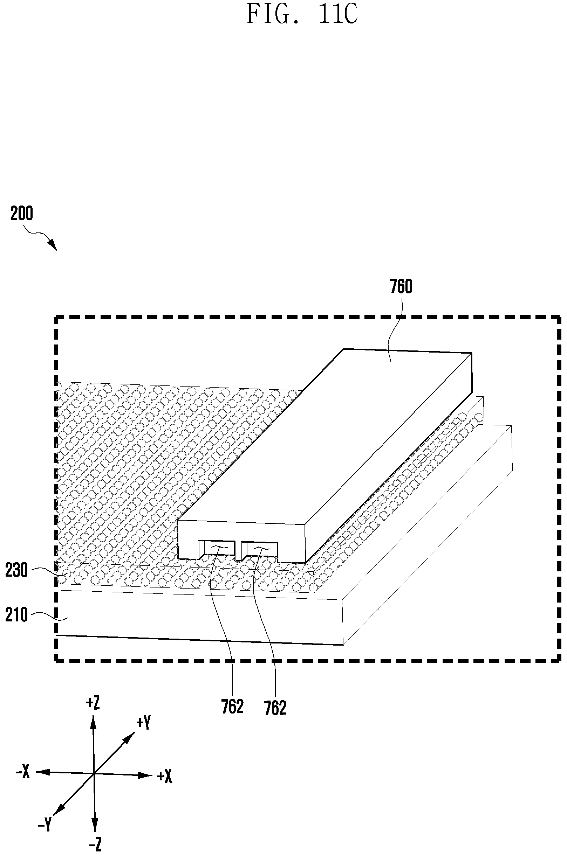

FIGS. 11A, 11B, and 11C are views illustrating the electronic device 200 including a heat transfer block 760 according to the embodiment of the present disclosure.

FIG. 11A is a conceptual view illustrating the electronic device 200 including the heat transfer block 760 according to the embodiment. FIG. 11B is a perspective view illustrating the electronic device 200 including the heat transfer block 760 according to the embodiment. FIG. 11C is a view illustrating an arrangement space 762 of the heat transfer block 760 according to the embodiment.

With reference to FIG. 11A, in the embodiment, the electronic device 200 may include the printed circuit board 210, the first connection part 220, the first electronic component 230, the second connection part 240, the second electronic component 250, the heat transfer block 760, and/or third electronic components 780.

With reference to FIGS. 11A and 11B, the heat transfer block 760 according to the embodiment may be disposed on the first electronic component 230. For example, the heat transfer block 760 may be disposed in the positive Z-axis direction of the first electronic component 230.

In the embodiment, the third electronic component 780 may be a passive element that accumulates, consumes, or passes supplied energy. For example, the third electronic component 780 may be a capacitor, an inductor, or a resistor.

With reference to FIGS. 11A and 11B, the third electronic component 780 may be disposed on at least a part of the heat transfer block 760.

In the embodiment, the third electronic component 780 may be disposed on the first electronic component 230 by using a reflow process. In the embodiment, the third electronic component 780 may be disposed by the reflow process together with the second electronic component 250 when the second electronic component 250 is disposed on the first electronic component 230.

With reference to FIG. 11C, the heat transfer block 760 according to the embodiment may include the arrangement space 762. The arrangement space 762 may be a space as a part of the heat transfer block 760 is recessed toward the inside of the heat transfer block 760.

In the embodiment, the arrangement space 762 may be formed in a shape corresponding to a shape of the third electronic component 780.

In the electronic device 200 including the heat transfer block 760 according to the embodiment, the third electronic component 780 may not be disposed on a part of the printed circuit board 210 (e.g., marked positions T in FIG. 11A) positioned to be opposite to the heat transfer block 760. In the electronic device 200 including the heat transfer block 760 according to the embodiment, at least a part of the third electronic component 780 is disposed to be surrounded by the heat transfer block 760, such that a space required to dispose the third electronic component 780 may be reduced.

In the embodiment, in the first electronic component 230, a temperature of the heat transferred to the third electronic component 780 and the heat transfer block 760 may be a temperature within a range in which the performance of the first electronic component 230 is not reduced. For example, in the first electronic component 230, the temperature of the heat transferred to the third electronic component 780 and the heat transfer block 760 may be lower than a predetermined temperature (e.g., 85 degrees).

In the embodiment, the third electronic component 780 may be a component having a function that may be maintained even at a temperature equal to or higher than the temperature of the heat transferred from the first electronic component 230. For example, in the first electronic component 230, in case that the temperature of the heat transferred to the third electronic component 780 is lower than at most 85 degrees, a temperature at which the function of the third electronic component 780 may be maintained may be at most 125 degrees.

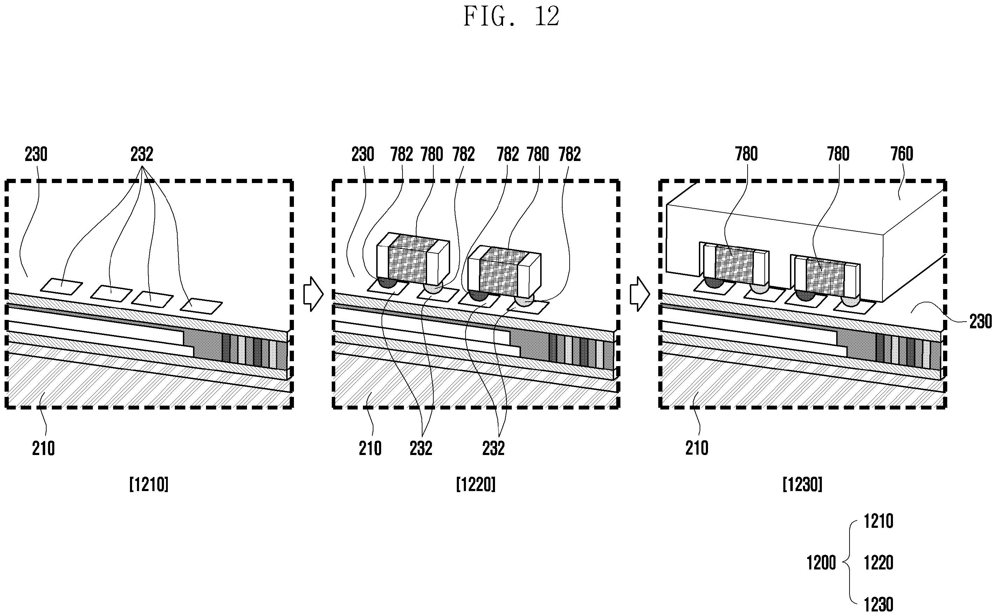

FIG. 12 is a view illustrating a first arrangement method 1200 according to the embodiment of the present disclosure.

In the electronic device 200 according to the embodiment, the heat transfer block 760 may be disposed on the first electronic component 230 in accordance with the first arrangement method 1200.

The first arrangement method 1200 according to the embodiment of the present disclosure may include a contact pad forming operation 1210, a component disposing operation 1220, and/or a heat transfer block disposing operation 1230.

In the embodiment, at the contact pad forming operation 1210, contact pads 232 may be formed on one surface of the first electronic component 230 (e.g., a surface of the first electronic component 230 directed in the positive Z-axis direction) disposed on the printed circuit board 210.

In the embodiment, the contact pad 232 may be a solder pad for electrically connecting the first electronic component 230 and the third electronic component 780.

In the embodiment, at the component disposing operation 1220, the third electronic components 780 may be disposed on the first electronic component 230. For example, the third electronic components 780 may be disposed on the contact pads 232 formed on the first electronic component 230. The third electronic component 780 may be disposed on the first electronic component 230 so that a contact portion 782 of the third electronic component 780 is in contact with the contact pad 232.

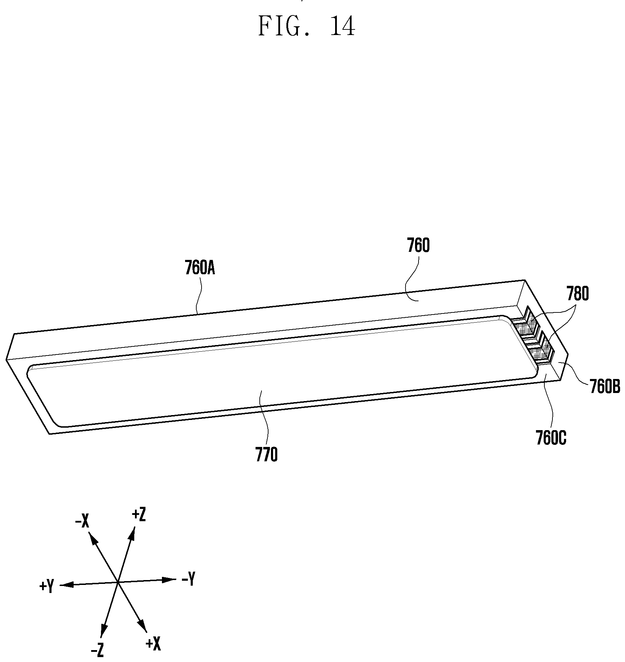

In the embodiment, at the heat transfer block disposing operation 1230, the heat transfer block 760 may be disposed on the first electronic component 230. The heat transfer block 760 may be attached to the first electronic component 230 to surround at least a part of the third electronic component 780. In the embodiment, the heat transfer block 760 may be attached to the first electronic component 230 with a heat transfer member 770 (see FIG. 14) interposed therebetween.

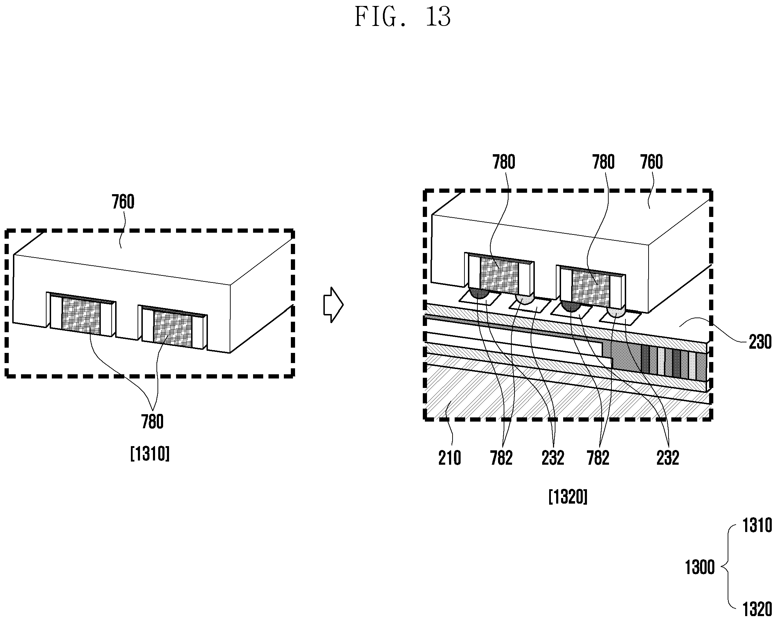

FIG. 13 is a view illustrating a second arrangement method 1300 according to the embodiment of the present disclosure.

In the electronic device 200 according to the embodiment, the heat transfer block 760 may be disposed on the first electronic component 230 in accordance with the second arrangement method 1300.

The second arrangement method 1300 according to the embodiment of the present disclosure may include an integrated block manufacturing operation 1310 and/or a heat transfer block disposing operation 1320.

In the embodiment, at the integrated block manufacturing operation 1310, the third electronic component 780 may be attached to the heat transfer block 760. The third electronic component 780 may be attached to the heat transfer block 760 by using a joining member.

In the embodiment, the joining member, which is used to attach the third electronic component 780 to the heat transfer block 760, may include a heat resistance joining tape including polyimide or silicone, and/or a joining material with insulation properties.

In the embodiment, at the heat transfer block disposing operation 1320, the heat transfer block 760, to which the third electronic component 780 is attached, may be disposed on the first electronic component 230 disposed on the printed circuit board 210. The heat transfer block 760 may be disposed on the first electronic component 230 so that the contact portion 782 of the third electronic component 780 is in contact with the contact pad 232.

FIG. 14 is a view illustrating the heat transfer block 760 and the heat transfer member 770 according to the embodiment of the present disclosure.

The heat transfer member 770 may be attached to the heat transfer block 760 according to the embodiment.

In the embodiment, the heat transfer member 770 may be disposed on the other surface 760C that is a surface directed in the direction opposite to one surface 760A of the heat transfer block 760. For example, the heat transfer member 770 may be disposed on the surface of the heat transfer block 760 directed in the negative Z-axis direction.

In the embodiment, an area of the other surface 760C of the heat transfer block 760 may be larger than an area occupied by the heat transfer member 770. For example, an area of the heat transfer member 770 may be about 60% to 80% of an area of the other surface 760C of the heat transfer block 760.

In the embodiment, the area occupied by the heat transfer member 770 is smaller than the area of the other surface 760C of the heat transfer block 760. Therefore, even though the arrangement space 762 (see FIG. 11C) is formed as a part of the other surface 760C of the heat transfer block 760 is processed during the process of manufacturing the electronic device 200, the heat transfer member 770 may not be affected by the processing.

In the embodiment, the heat transfer member 770 may be disposed so as not to overlap the third electronic component 780. For example, with reference to FIG. 14, the third electronic component 780 may be disposed in the arrangement space 762 (see FIG. 11C) defined by a side surface 760B and the other surface 760C of the heat transfer block 760, and the heat transfer member 770 may be disposed so as not to overlap the arrangement space 762 (see FIG. 11C).

In the embodiment, because the heat transfer member 770 does not overlap the third electronic component 780, it is possible to prevent or reduce a situation in which the heat transfer member 770 is affected by the process of disposing the third electronic component 780.

In the embodiment, the heat transfer member 770 may be disposed between the heat transfer block 760 and the first electronic component 230 (see FIG. 11A). The heat transfer member 770 may transfer heat, which is generated from the first electronic component 230 (see FIG. 11A), to the heat transfer block 760. In the embodiment, the heat transfer member 770 may include a heat transfer material (thermal interface material (TIM)).

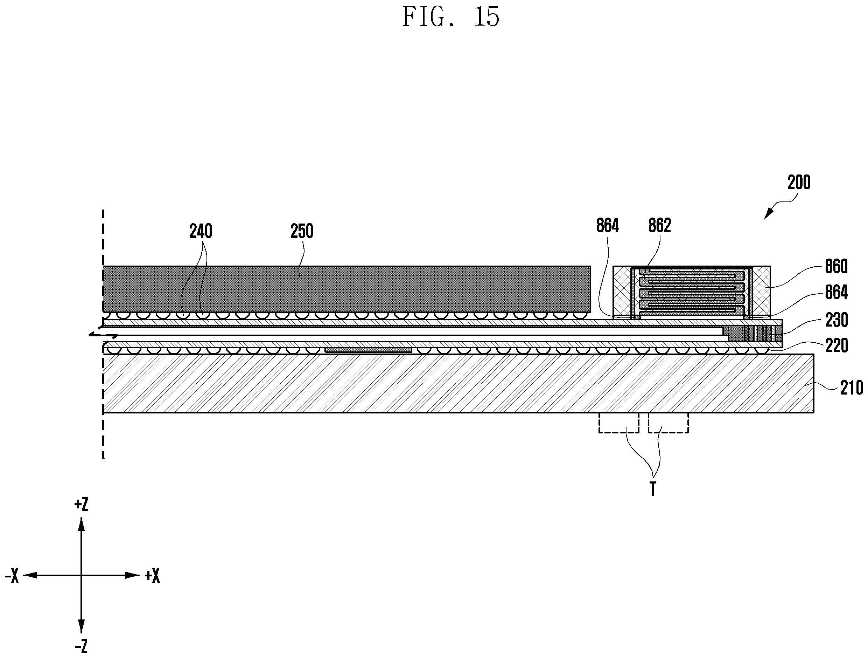

FIG. 15 is a view illustrating the electronic device 200 including a heat transfer block 860 according to the embodiment of the present disclosure.

With reference to FIG. 15, in the embodiment, the electronic device 200 may include the printed circuit board 210, the first connection part 220, the first electronic component 230, the second connection part 240, the second electronic component 250, and/or the heat transfer block 860.

With reference to FIG. 15, the heat transfer block 860 according to the embodiment may be disposed on the first electronic component 230. For example, the heat transfer block 860 may be disposed in the positive Z-axis direction of the first electronic component 230.

In the embodiment, the heat transfer block 860 may include a dielectric material 862. The heat transfer block 860 may include the dielectric material 862 and serve as a passive element. For example, the heat transfer block 860 including the dielectric material 862 may serve as a capacitor, an inductor, or a resistor.

In the embodiment, the heat transfer block 860 may be electrically connected to the first electronic component 230 through a contact portion 864.

In the electronic device 200 including the heat transfer block 860 according to the embodiment, the passive element (e.g., the third electronic component 280 in FIG. 2 or the third electronic component 780 in FIG. 11A) may not be disposed directly on a part of the printed circuit board 210 (e.g., marked positions T in FIG. 15). In the electronic device 200 including the heat transfer block 860 according to the embodiment, the passive element (e.g., the third electronic component 780 in FIG. 11A) is not disposed on the printed circuit board 210 but implemented by the dielectric material 862 of the heat transfer block 860, such that the space required to dispose the passive element (e.g., the third electronic component 780 in FIG. 11A) may be reduced.

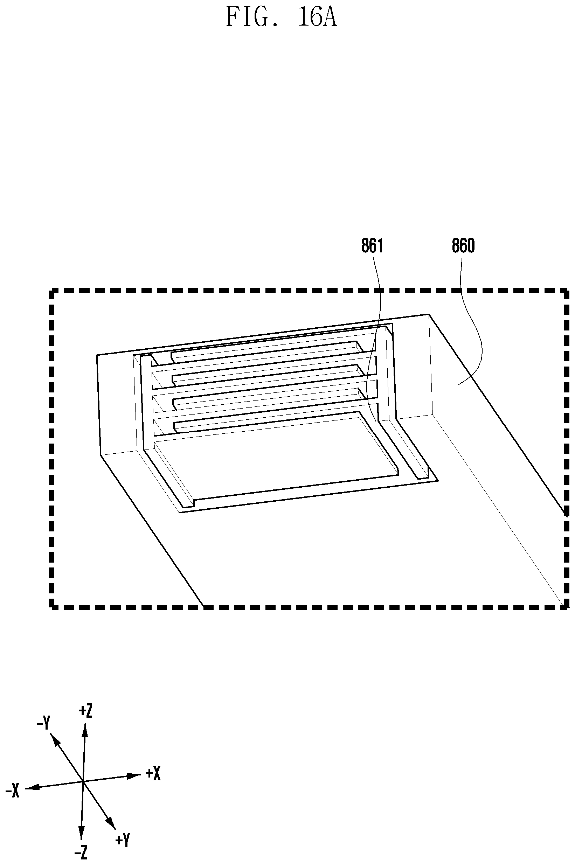

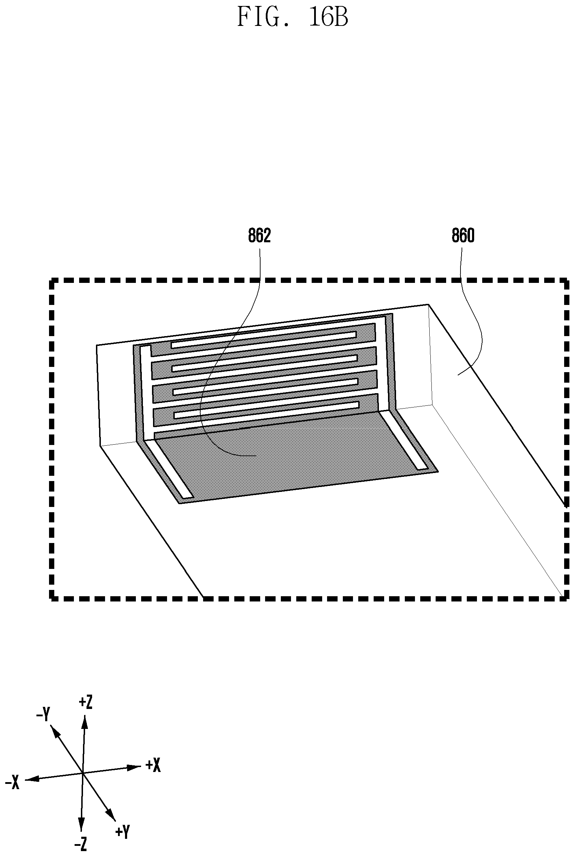

FIGS. 16A and 16B are views illustrating the heat transfer block 860 according to the embodiment of the present disclosure.

FIG. 16A is a view illustrating the heat transfer block 860 including a filling space 861 according to the embodiment. FIG. 16B is a view illustrating the heat transfer block 860 including the dielectric material 862 according to the embodiment.

With reference to FIG. 16A, the heat transfer block 860 according to the embodiment may include the filling space 861. The filling space 861 may be a space formed by removing a part of the heat transfer block 860.

With reference to FIG. 16B, the filling space 861 of the heat transfer block 860 may be filled with the dielectric material 862. The heat transfer block 860 including the dielectric material 862 may serve as a passive element. For example, the heat transfer block 860 including the dielectric material 862 may serve as a capacitor, an inductor, or a resistor.

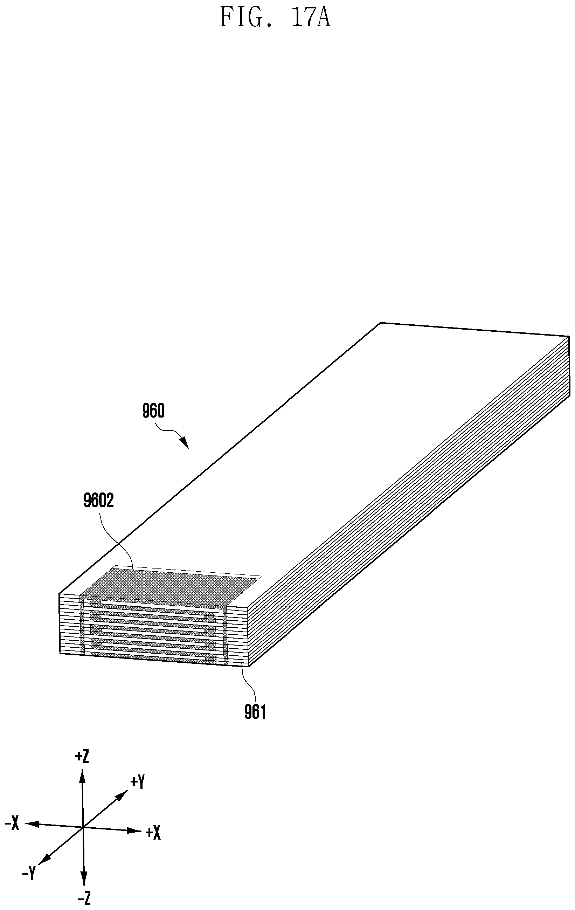

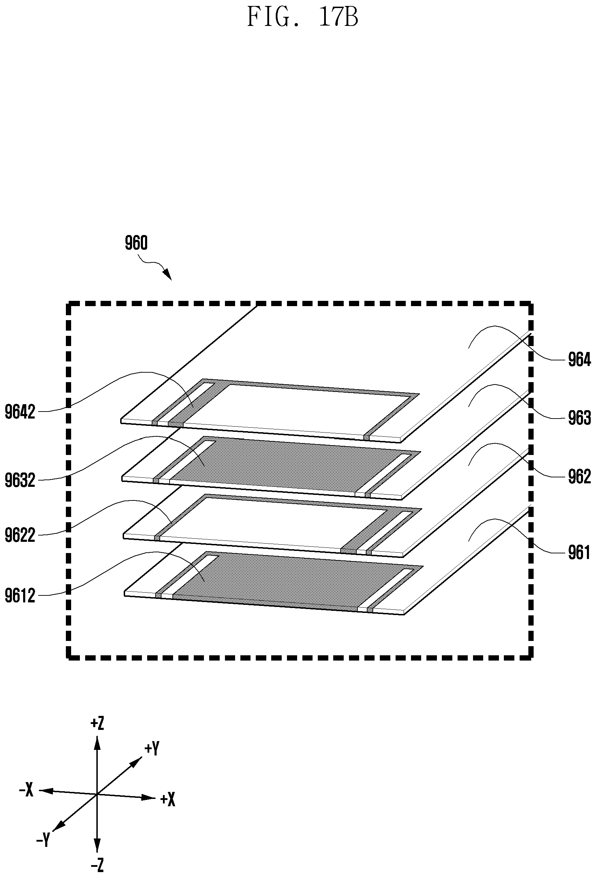

FIGS. 17A and 17B are views illustrating a heat transfer block 960 according to the embodiment of the present disclosure.

FIG. 17A is a view illustrating the heat transfer block 960 made by stacking a plurality of plates 961. FIG. 17B is a view illustrating a plurality of plates 961, 962, 963, and 964 that constitutes the heat transfer block 960.

In the description of the heat transfer block 960 according to the embodiment of the present disclosure, the width direction of the heat transfer block 960 may mean the X-axis direction, and the longitudinal direction of the heat transfer block 960 may mean the Y-axis direction. The height direction of the heat transfer block 960 may mean the Z-axis direction.

With reference to FIG. 17A, the heat transfer block 960 according to the embodiment may be formed by stacking the plurality of plates (e.g., the plate 961 in FIG. 17A or the plates 961, 962, 963, and 964 in FIG. 17B) in the height direction (e.g., the Z-axis direction) of the heat transfer block 960.

With reference to FIG. 17B, the heat transfer block 960 may include the plurality of plates 961, 962, 963, and 964. The plurality of plates 961, 962, 963, and 964 may each extend in the width direction (e.g., the X-axis direction) and the longitudinal direction (e.g., the Y-axis direction) of the heat transfer block 960 and having a thickness in the height direction (e.g., the Z-axis direction) of the heat transfer block 960.

In the embodiment, the heat transfer block 960 may include a first plate 961, a second plate 962, a third plate 963, and/or a fourth plate 964.

With reference to FIG. 17B, the plurality of plates 961, 962, 963, and 964 may include dielectric layers 9612, 9622, 9632, and 9642 formed as patterns. For example, the first plate 961 may include a first dielectric layer 9612. The second plate 962 may include a second dielectric layer 9622. The third plate 963 may include a third dielectric layer 9632. The fourth plate 964 may include a fourth dielectric layer 9642.

In the embodiment, the plurality of plates (e.g., 961) including the dielectric layers 9612, 9622, 9632, and 9642 may be manufactured, and then the plurality of plates 961, 962, 963, and 964 may be stacked, such that the heat transfer block 960 may be formed.

In the embodiment, the plurality of plates (e.g., 961) may be stacked in the height direction (e.g., the Z-axis direction) of the heat transfer block 960. In the embodiment, the plurality of plates (e.g., 961) may be stacked by a thermal process, a pressing process, or a plating joining process.

In the embodiment, the heat transfer block 960 including a dielectric material 9602 may be formed by stacking the plurality of plates (e.g., 961) in the height direction (e.g., the Z-axis direction) of the heat transfer block 960. The heat transfer block 960, which is formed by stacking the plurality of plates (e.g., 961), may have a predetermined characteristic value (e.g., capacitance).

In the embodiment, the dielectric layers 9612, 9622, 9632, and 9642 may be formed in different shapes.

FIG. 17B illustrates that the heat transfer block 960 is formed by stacking the first plate 961 having the first dielectric layer 9612, the second plate 962 having the second dielectric layer 9622, the second plate 963 having the third dielectric layer 9632, and the fourth plate 964 having the fourth dielectric layer 9642. However, this configuration is provided for illustrative purposes only. The shape in which the plates 961, 962, 963, and 964 are stacked to form the heat transfer block 960 may not be limited thereto.

In the embodiment, the heat transfer block 960 may be formed by stacking the plurality of plates 961, 962, 963, and 964 having the dielectric layers 9612, 9622, 9632, and 9642 having the same shapes. For example, in the embodiment, the heat transfer block 960 may be formed by stacking the plurality of first plates 961 having the first dielectric layers 9612. Alternatively, in the embodiment, the heat transfer block 960 may be formed by stacking the plurality of second plates 962 having the second dielectric layers 9622. Alternatively, in the embodiment, the heat transfer block 960 may be formed by stacking the plurality of third plates 963 having the third dielectric layers 9632. Alternatively, in the embodiment, the heat transfer block 960 may be formed by stacking the plurality of fourth plates 964 having the fourth dielectric layers 9642.

In the embodiment, some of the heat transfer blocks 960 may include the plurality of plates 961, 962, 963, and 964 having the dielectric layers 9612, 9622, 9632, and 9642 having the same shape, and some of the remaining heat transfer blocks 960 may include the plates 961, 962, 963, and 964 having the dielectric layers 9612, 9622, 9632, and 9642 having different shapes. For example, some of the heat transfer blocks 960 may include two or more first plates 961 having the first dielectric layers 9612, and some of the remaining heat transfer blocks 960 may include the plates 962, 963, and 964 including the dielectric layers 9622, 9632, and 9642 different in shapes from the first dielectric layer 9612.

In the embodiment, the predetermined characteristic value (e.g., capacitance) of the heat transfer block 960 may vary depending on the shapes of the dielectric layers 9612, 9622, 9632, and 9642 included in the heat transfer block 960.

The heat transfer block 960 according to the embodiment may be disposed on the first electronic component 230 (see FIG. 15) of the electronic device 200 (see FIG. 15).

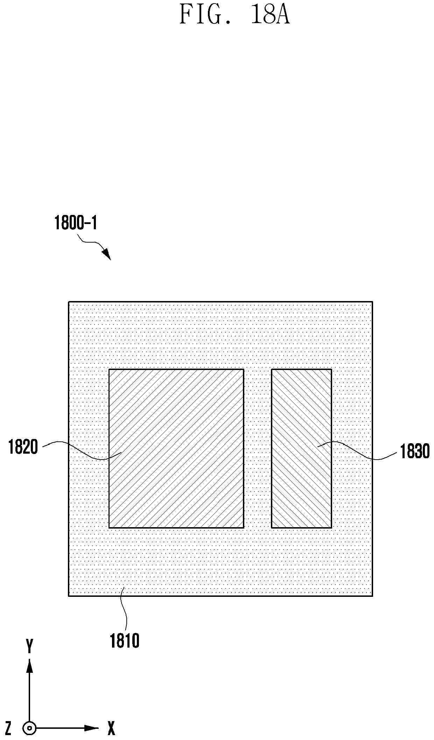

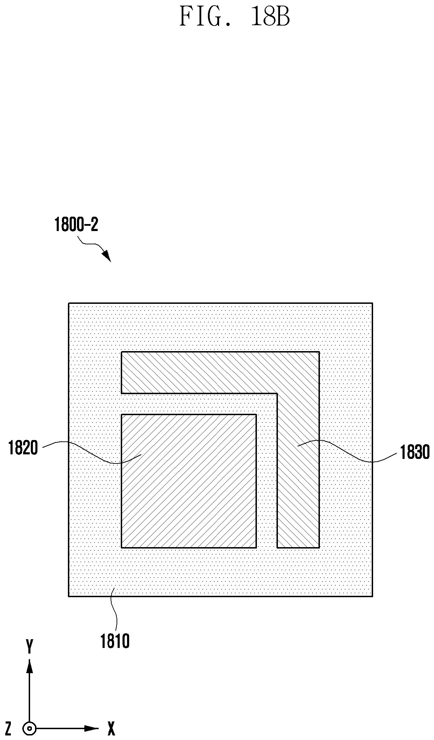

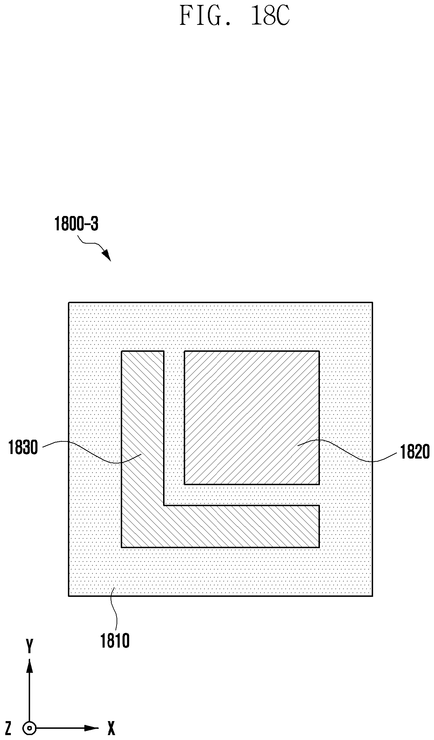

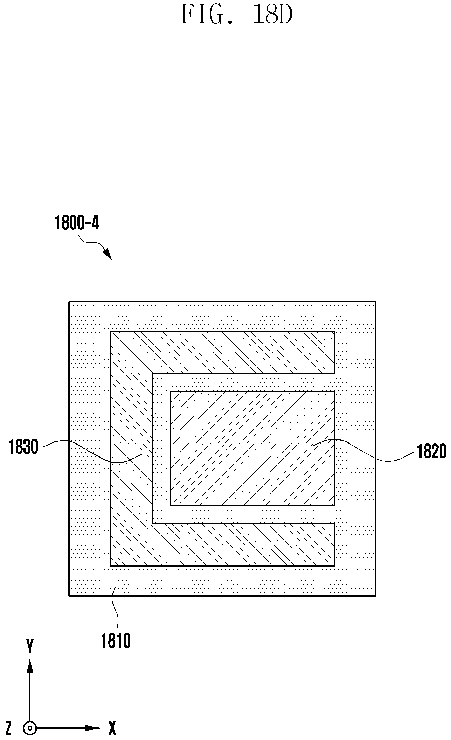

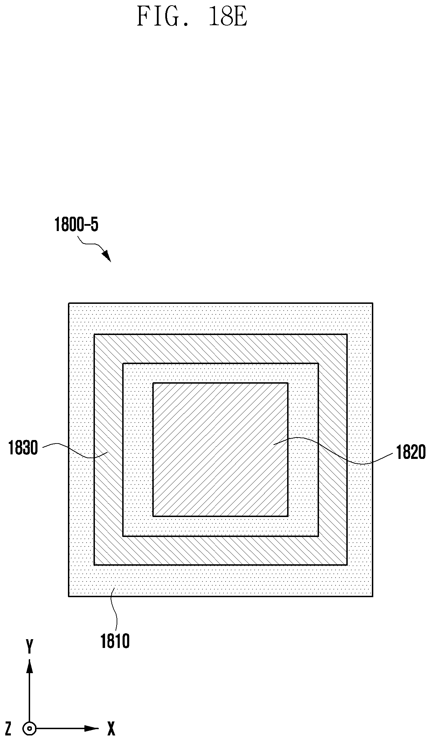

FIGS. 18A, 18B, 18C, 18D, and 18E are views illustrating a heat transfer block 1830 according to the embodiment of the present disclosure.

With reference to FIGS. 18A, 18B, 18C, 18D, and 18E, electronic devices 1800-1, 1800-2, 1800-3, 1800-4, and 1800-5 according to the embodiment may each include a first electronic component 1810, a second electronic component 1820, and/or a third electronic component 1830.

The electronic devices 1800-1, 1800-2, 1800-3, 1800-4, and 1800-5 illustrated in FIGS. 18A, 18B, 18C, 18D, and 18E may each mean the electronic device 200 in FIG. 5, the electronic device 200 in FIG. 7, the electronic device 200 in FIG. 11A, or the electronic device 200 in FIG. 15 or include at least some of the constituent elements of the electronic device 200 in FIG. 5, the electronic device 200 in FIG. 7, the electronic device 200 in FIG. 11A, or the electronic device 200 in FIG. 15.

In the embodiment, the first electronic component 1810 may include the printed circuit board 210 (see FIG. 2).

In the embodiment, the first electronic component 1810 may include a system-on-chip (SOC) made by implementing at least one semiconductor element (e.g., a central processing unit or the like) into one chip. The first electronic component 1810 may be a heat generation component that generates heat while operating.

In the embodiment, the first electronic component 1810 may include the electronic component (e.g., the first electronic component 230 in FIG. 2) electrically connected to the printed circuit board 210 (see FIG. 2).

In the embodiment, the second electronic component 1820 may be the memory device (e.g., the DRAM) configured to store data used by the constituent elements of the electronic devices 1800-1, 1800-2, 1800-3, 1800-4, and 1800-5.

In the embodiment, the second electronic component 1820 may be disposed on the first electronic component 1810.

In the embodiment, the heat transfer block 1830 may serve to move heat transferred from the first electronic component 1810.

In the embodiment, the heat transfer block 1830 may mean the heat transfer block 260 in FIG. 5, the heat transfer block 360 in FIG. 7, the heat transfer block 760 in FIG. 11A, or the heat transfer block 860 in FIG. 15 or include at least some of the constituent elements of the heat transfer block 260 in FIG. 5, the heat transfer block 360 in FIG. 7, the heat transfer block 760 in FIG. 11A, or the heat transfer block 860 in FIG. 15.

In the embodiment, the shape of the heat transfer block 1830 and the arrangement shapes of the second electronic component 1820 and the heat transfer block 1830 may vary depending on the electronic devices 1800-1, 1800-2, 1800-3, 1800-4, and 1800-5.

With reference to FIG. 18A, in the electronic device 1800-1 according to the embodiment, the heat transfer block 1830 may extend in one direction (e.g., the Y-axis direction). In the electronic device 1800-1 according to the embodiment, the heat transfer block 1830 may be spaced apart from one side surface of the second electronic component 1820 in the X-axis direction.

With reference to FIGS. 18B and 18C, in the electronic devices 1800-2 and 1800-3 according to the embodiment, the heat transfer block 1830 may extend in the longitudinal direction (e.g., the X-axis direction) and the width direction (e.g., the Y-axis direction) of the electronic devices 1800-2 and 1800-3. In the electronic devices 1800-2 and 1800-3 according to the embodiment, the heat transfer block 1830 may be spaced apart from the second electronic component 1820 in the X-axis direction and the Y-axis direction. In the electronic devices 1800-2 and 1800-3 according to the embodiment, the heat transfer block 1830 may be formed to face two side surfaces of the second electronic component 1820.

With reference to FIG. 18D, in the electronic device 1800-4 according to the embodiment, the heat transfer block 1830 may extend in the longitudinal direction (e.g., the X-axis direction) and the width direction (e.g., the Y-axis direction) of the electronic device 1800-4. In the electronic device 1800-4 according to the embodiment, the heat transfer block 1830 may be spaced apart from the second electronic component 1820 in the X-axis direction and the Y-axis direction. In the electronic device 1800-4 according to the embodiment, the heat transfer block 1830 may be formed to face three side surfaces of the second electronic component 1820.

With reference to FIG. 18E, in the electronic device 1800-5 according to the embodiment, the heat transfer block 1830 may extend to have a quadrangular peripheral shape. In the electronic device 1800-5 according to the embodiment, the heat transfer block 1830 may be disposed to surround an outer periphery of the second electronic component 1820. In the electronic device 1800-5 according to the embodiment, the heat transfer block 1830 may be spaced apart from the second electronic component 1820 in the X-axis direction and the Y-axis direction. In the electronic device 1800-5 according to the embodiment, the heat transfer block 1830 may be formed to face four side surfaces of the second electronic component 1820.

The resin may be applied to reduce cracks in the solder ball of the ball grid array (BGA) formed between the first electronic component 230 and the second electronic component 250.

The resin may be injected into the ball grid array (BGA) positioned between the first electronic component 230 and the second electronic component 250 through the space between the second electronic component 250 and the heat transfer block 260.

In case that the space between the second electronic component 250 and the heat transfer block 260 is narrow, it may be difficult to inject the resin into the space between the first electronic component 230 and the second electronic component 250.

The electronic device 200 according to the embodiment of the present disclosure may include the printed circuit board 210, the first electronic component 230 disposed on the printed circuit board 210, the second electronic component 250 disposed on the first electronic component 230, the heat transfer block 260, 360, 760, 860, 960, or 1830 disposed on the first electronic component 230 and spaced apart from the second electronic component 250, and the resin material formed between the first electronic component 230 and the second electronic component 250.

In the embodiment, the electronic device 200 may include the heat transfer blocks 260, 360, 760, 860, 960, or 1830 and easily transfer the heat generated from the electronic component (e.g., the first electronic component 230) to another area.

In the embodiment, the heat transfer block 260 may include the injection port 261 formed in the heat transfer block, the discharge port 263 directed toward the space between the first electronic component 230 and the second electronic component 250, and the resin flow space 265 formed between the discharge port 263 and the injection port 261.

In the embodiment, the resin RES material formed between the first electronic component 230 and the second electronic component 250 may be injected in advance through the injection port 261, the resin flow space 265, and the discharge port 263 that guide the resin RES material to the space between the first electronic component 230 and the second electronic component 250.

In the embodiment, the number of discharge ports 263 may be larger than the number of injection ports 261.

In the embodiment, the heat transfer block 260 may include the inclined surface 262 formed at one side of the resin flow space 265 and connected to the discharge port 263 and the injection port 261, the inclined surface 262 is inclined with respect to the height direction of the electronic device 200, and a width of the inclined surface 262 may increase toward the discharge port 263.

In the embodiment, the electronic device 200 may include the heat transfer block formed between the inclined surface 262 and the resin flow space 265, which makes it easy to inject the resin into the ball grid array positioned between the first electronic component 230 and the second electronic component 250.

In the embodiment, the resin flow space 265 may have a funnel shape having a space that expands toward the discharge port 263 from the injection port 261.

In the embodiment, the plurality of injection ports 261, the plurality of discharge ports 263, and the plurality of resin flow spaces 265 may be formed at intervals in the width direction of the electronic device 200.

In the embodiment, the electronic device 200 guides a flow of the resin to the inclined surface 262 and the resin flow space 265, such that the entire space between the first electronic component 230 and the second electronic component 250 is uniformly filled with the resin.

In the embodiment, the electronic device 200 may include the heat transfer member 270 disposed between the first electronic component 230 and the heat transfer block 260.

In the embodiment, the heat transfer member 270 may extend in the longitudinal direction and the width direction of the heat transfer block 260, and the distal end of the heat transfer member 270 may be spaced apart from the discharge port 263.

In the embodiment, the resin flow space 265 may guide the resin RES material, which is injected into the electronic device 200 during the process of manufacturing the electronic device 200, so that the resin RES material flows in a predetermined direction.

In the embodiment, the heat transfer block 360 may include the resin storage space 361 configured to store the resin RES introduced into the electronic device 200.

In the embodiment, the resin storage space 361 may be formed as a part of the surface of the heat transfer block 360, which faces the second electronic component 250, is concavely recessed.

In the embodiment, the resin flow space 265 and the resin storage space 361 may be formed alternately in the surface heat transfer block, which faces the second electronic component 250, in the width direction of the electronic device.

In the embodiment, the electronic device 200 includes the heat transfer block 360 having the resin storage space 361, which may prevent or reduce an overflow of the resin during the process of injecting the resin.

In the embodiment, the electronic device 200 or 1000 may include the shield can 1080 configured to surround the first electronic component 230 or 1020 and the second electronic component 250 or 1030 and including the shield can opening 1081, and the shield member 1090 configured to cover the shield can opening 1081, and the heat generated from the first electronic component 230 or 1020 may be transferred to the outside of the electronic device 200 or 1000 through the heat transfer block 260 or 1070 and the shield member 1090.

The electronic device 200 according to the embodiment of the present disclosure may include the first electronic component 210 or 230, the second electronic component 250 electrically coupled to the first electronic component 210 or 230 via a plurality of solder balls, the heat transfer blocks 260, 360, 760, 860, 960, or 1830 disposed on the first electronic component 210 or 230 and spaced apart from the second electronic component 250, and the resin RES material formed between the first electronic component 210 or 230 and the second electronic component 250, in which the heat transfer block 260 includes the resin flow space 265 provided by the heat transfer block 260, and in which the resin flow space (e.g., the inclined surface 262 in FIG. 2 or the resin flow space 265 in FIG. 5) is configured to guide the resin RES material between the first electronic component 210 or 230 and the second electronic component 250 during the process of manufacturing the electronic device 200.

In the embodiment, the first electronic component 210 or 230 may include the printed circuit board 210.

In the embodiment, the first electronic component 210 or 230 may include the system-on-chip (SOC) 230.

According to an embodiment of the disclosure, there is provided an electronic device comprising: a first electronic component; a second electronic component disposed on the first electronic component; a heat transfer block disposed on the first electronic component and spaced apart from the second electronic component; and a resin material formed between the first electronic component and the second electronic component, wherein the heat transfer block comprises: an inclined surface which is inclined with respect to a surface of the first electronic device on which the heat transfer block is disposed and arranged such that, when the electronic device is positioned with the heat transfer block above the first electronic component, resin flowing on the inclined surface will flow towards a gap between the first electronic component and the second electronic component.

In an electronic device according to the embodiment, the inclined surface may be an outer surface of the heat transfer block. In an electronic device according to the embodiment, the inclined surface may be enclosed within the heat transfer block. The inclined surface may be a surface of a resin flow space. The resin flow space may be located within the heat transfer block. A surface of the resin flow space may be defined by a surface of the second electronic component.

The first electronic component may comprise a printed circuit board. The first electronic component may comprise a system-on-chip.

The electronic device may comprise a heat transfer member disposed between the first electronic component and the heat transfer block.

The heat transfer block further comprises a resin storage space which is configured to store resin introduced into the electronic device. The resin storage space may be formed as part of a surface of the heat transfer block which faces the second electronic component. The resin storage space may be concavely recessed in the heat transfer block.

According to an embodiment of the disclosure, there is provided an electronic device comprising: a first electronic component; a second electronic component disposed on the first electronic component; a heat transfer block disposed on the first electronic component and spaced apart from the second electronic component; and a resin material formed between the first electronic component and the second electronic component, wherein the heat transfer block comprises a resin storage space which is configured to store resin introduced into the electronic device. The resin storage space may be formed as part of a surface of the heat transfer block which faces the second electronic component. The resin storage space may be concavely recessed in the heat transfer block.

The first electronic component may comprise a printed circuit board. The first electronic component may comprise a system-on-chip.

The electronic device may comprise a heat transfer member disposed between the first electronic component and the heat transfer block.

According to an embodiment of the disclosure, there is provided a method of manufacturing an electronic device, the method comprising: disposing a second electronic component and heat transfer block on a first electronic component; and flowing fluid resin through or across the heat transfer block such that it flows into a space between the second electronic component and the first electronic component, wherein the first electronic component is an electronic component according to any embodiment described herein, the second electronic component is an electronic component according to any embodiment described herein, and the heat transfer block is a heat transfer block according to any embodiment described herein.

Technical problems to be solved by the present disclosure are not limited to the above-mentioned technical problems, and other technical problems, which are not mentioned above, may be clearly understood by those skilled in the art to which the present disclosure pertains.

The effects obtained by the present disclosure are not limited to the aforementioned effects, and other effects, which are not mentioned above, will be clearly understood by those skilled in the art.

It will be appreciated that all of the above-described embodiments, and their technical features, may be combined with one another in each and every combination, potentially unless there is a conflict between two embodiments or features. That is, each and every combination of two or more of the above-described embodiments is envisaged and included within the present disclosure. One or more features from any embodiment may be incorporated in any other embodiment, and provide a corresponding advantage or advantages.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration.

According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (200) comprising:
a printed circuit board (210);
a first electronic component (230) disposed on the printed circuit board;
a second electronic component (250) disposed on the first electronic component;
a heat transfer block (260, 360, 760, 860, 960, 1830) disposed on the first electronic component and spaced apart from the second electronic component; and
a resin material formed between the first electronic component and the second electronic component,
wherein the heat transfer block comprises:
an injection port (261) formed in the heat transfer block;
a discharge port (263) toward a space between the first electronic component and the second electronic component; and
a resin flow space (265) formed between the discharge port and the injection port.

2. The electronic device of claim 1, wherein the resin material formed between the first electronic component and the second electronic component was previously injected through the injection port, the resin flow space, and the discharge port guiding the resin material to the space between the first electronic component and the second electronic component.

3. The electronic device of claim 1, wherein the number of discharge ports is greater than the number of injection ports.

4. The electronic device of claim 1, wherein the heat transfer block further comprises an inclined surface (262) formed at one side of the resin flow space and connected to the discharge port and the injection port, and
wherein the inclined surface is formed to be inclined based on the height direction of the electronic device and becomes longer in width as it approaches the outlet.

5. The electronic device of claim 1, wherein the resin flow space has a funnel shape having a space that expands toward the discharge port from the injection port.

6. The electronic device of claim 1, wherein a plurality of injection ports, a plurality of discharge ports, and a plurality of resin flow spaces are formed at intervals in a width direction of the electronic device.

7. The electronic device of claim 1, further comprising:
a heat transfer member (270) disposed between the first electronic component and the heat transfer block, and
wherein the heat transfer member extends in a longitudinal direction and a width direction of the heat transfer block, and a distal end of the heat transfer member is spaced apart from the discharge port.

8. The electronic device of claim 1, wherein the heat transfer block further comprises a resin storage space (361) configured to store resin introduced into the electronic device, and
wherein the resin storage space is formed as a part of a surface of the heat transfer block, which faces the second electronic component, is concavely recessed.

9. The electronic device of claim 8, wherein the resin flow space and the resin storage space are formed alternately in a width direction of the electronic device in a surface of the heat transfer block that faces the second electronic component.

10. The electronic device of claim 1, further comprising:
a shield can (1080) configured to surround the first electronic component and the second electronic component and comprising a shield can opening (1081); and
a shield member (1090) configured to cover the shield can opening,
wherein heat generated from the first electronic component is transferred to the outside of the electronic device through the heat transfer block and the shield member.

11. An electronic device (200) comprising:
a first electronic component (210 or 230);
a second electronic component (250) electrically coupled to the first electronic component via a plurality of solder balls;
a heat transfer block (260, 360, 760, 860, 960, 1830) disposed on the first electronic component and spaced apart from the second electronic component; and
a resin material formed between the first electronic component and the second electronic component,
wherein the heat transfer block comprises:
a resin flow space (262, 265) provided by the heat transfer block, and
wherein the resin flow space is configured to guide resin material between the first electronic part and the second electronic part during manufacturing

12. The electronic device of claim 11, wherein the first electronic component is a printed circuit board or a system-on-chip (SOC) (230).

13. The electronic device of claim 11, further comprising:
a heat transfer member (270) disposed between the first electronic component and the heat transfer block.

14. The electronic device of claim 11, wherein the heat transfer block further comprises a resin storage space (361) configured to store resin introduced into the electronic device, and
wherein the resin storage space is formed as a part of a surface of the heat transfer block, which faces the second electronic component, is concavely recessed.

15. The electronic device of claim 14, wherein the resin flow space and the resin storage space are formed alternately in a width direction of the electronic device in a surface of the heat transfer block that faces the second electronic component.
